# EUROPEAN PATENT APPLICATION

(11) **EP 1 806 774 A1**
(43) Date of publication of application: **11.07.2007**
(21) Application number: 05799166.3
(22) Date of filing: 24.10.2005
(51) Int. Cl.: H01L 21/027, G03F 1/14, G03F 9/00, H01L 21/673

(54) **RETICLE PROTECTIVE MEMBER, RETICLE CARRYING APPARATUS, EXPOSURE DEVICE, AND RETICLE CARRYING METHOD**

(30) Priority: 29.10.2004 JP 2004315250; 19.11.2004 JP 2004335348
(71) Applicant: NIKON CORPORATION, Tokyo 100-8331 (JP)
(72) Inventor: SUZUKI, Motoko c/o NIKON CORPORATION, Chiyoda-ku, Tokyo 1008331 (JP); OKUBO, Yukiharu c/o NIKON CORPORATION, Chiyoda-ku, Tokyo 1008331 (JP)
(74) Representative: Savic, Bojan
(86) International application number: PCT/JP2005/019853
(87) International publication number: WO 2006/046682

(57) **Abstract**

The position measuring device 29 measures the positions of the position measurement marks 26 formed on the undersurface of the reticle 1, thus measuring the position of the reticle 1. The position measuring device 30 measures the positions of the position measurement marks 27 formed on the undersurface of the lower cover 2b, thus measuring the position of the lower cover 2b. Once the position of the reticle 1 and the position of the lower cover 2b are ascertained, the relative positional deviation between the reticle 1 and lower cover 2b is ascertained. Accordingly, when the lower cover 2b carrying the reticle 1 is conveyed and set in an exposure apparatus by a conveying device, the reticle 1 can be accurately set in the exposure apparatus by determining the position where the lower cover 2b is to be stopped with this deviation being taken into account.

## Description

### Technical Field

The present invention relates to a reticle protective member, reticle conveying device, exposure apparatus, and reticle conveying method, and particularly relates to devices that are suitable in cases where an EUV exposure apparatus is the object.

### Background Art

As semiconductor integrated circuits become finer, projection lithography techniques using EUV light having shorter wavelengths (11 to 14 nm) instead of conventional ultraviolet light have been developed in recent years in order to improve the resolution of the optical system that is restricted by the diffraction limit of light. In these days, such techniques are called EUV (extreme ultraviolet) lithography, and are showing promise as techniques for obtaining a resolution of 70 nm or better, which is impossible to realize in conventional photolithography using light rays having a wavelength of approximately 190 nm.

The complex refractive index n of a substance in the wavelength region of EUV light is expressed as n = 1-δ-ik (i being a complex symbol). The imaginary part k of this refractive index indicates absorption of extreme ultraviolet light. Since δ and k are much smaller than 1, the refractive index in this region is extremely close to 1. Accordingly, transmission refraction type optical elements such as conventional lenses cannot be used, so that optical systems utilizing reflection are used.

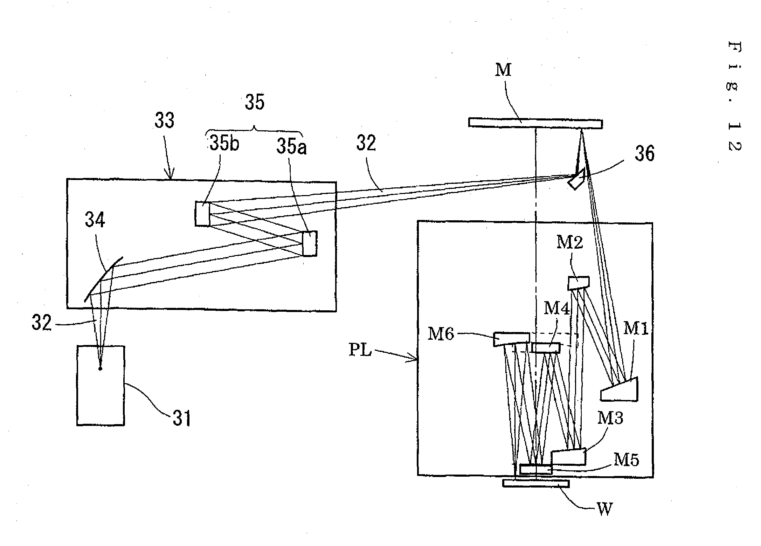

An outline of such an EUV exposure apparatus is shown in Figure 12. EUV light 32 emitted from an EUV light source 31 is incident on an illumination optical system 33, becomes substantially parallel light beams via a concave reflective mirror 34 that acts as a collimator mirror, and is incident on an optical integrator 35 consisting of a pair of fly-eye mirrors 35a and 35b. The fly-eyes mirrors disclosed in U.S. Patent No. 6452661 (Patent Reference 1), for example, can be used as the pair of fly-eye mirrors 35a and 35b. Furthermore, since the construction and action of fly-eye mirrors are described in more detail in Patent Reference 1, such a description is omitted for the convenience of explanation.

Thus, a substantive surface illuminant having a specified shape is formed in the vicinity of the reflective surface of the second fly-eye mirror 35b, i.e., in the vicinity of the emission surface of the optical integrator 35. The light from the substantive surface illuminant is deflected by a flat reflective mirror 36, after which a slender circular arc-form illumination region is formed on a reticle R (an aperture plate used to form the circular arc-form illumination region is omitted from illustration). The light from the pattern of the illuminated reticle R forms an image of the reticle pattern on a wafer W via a projection optical system PL consisting of a plurality of reflective mirrors (six reflective mirrors M1 through M6 are shown as examples in Figure 12). Furthermore, the reticle R is held on the reticle stage, and the wafer W is held on the wafer stage. The entire image of the pattern of the surface of reticle R is transferred onto the wafer W by causing the reticle stage and wafer stage to move (scan); the reticle stage and wafer stage are omitted from illustration.

Since EUV light is absorbed by air as well, the interior of the lens barrel must be maintained in a high degree of vacuum, so that special designing is required for the reticle conveying system.

Moreover, reflective type reticles are also used as reticles that are used in such an EUV exposure apparatus. In a reticle used in an exposure apparatus using ordinary visible light or ultraviolet light, a transparent thin film referred to as a pellicle is used to protect the pattern surface. However, since there is no transparent material in an EUV exposure apparatus as described above, a pellicle cannot be formed, so that the pattern surface is exposed. Accordingly, it is necessary to protect the pattern surface using another means so that no foreign matter adheres to the pattern surface when conveying or storing the reticle.

In addition, in cases where a reticle is conveyed, if the reticle is directly conveyed by a conveying device, there is a danger that the pattern surface will be damaged by contact between the reticle and conveying device, or that dirt will be generated as a result of the conveying device rubbing against parts other than the pattern surface. Accordingly, it is desirable to use a system which is such that the reticle is placed in a state in which this reticle is protected by a protective member, and that the protective member is conveyed.

However, in cases where a system is used in which a protective member that protects the entire reticle or pattern surface is conveyed for this purpose, there is a possibility that the reticle cannot be attached in a suitable position if the relative positional relationship between the reticle and protective member is shifted when the reticle is attached to the reticle stage after the protective member is conveyed to the reticle stage.

### Disclosure of the Invention

The present invention was devised in light of such circumstances; it is an object of the present invention to provide a reticle conveying device which allows the attachment of a reticle in a suitable position in cases where this reticle is conveyed and attached to the reticle stage of an exposure apparatus even in cases where a protective member that protects the entire reticle or the pattern surface of the reticle is provided, a reticle protective member that is suitable to be used for this purpose, an exposure apparatus that has such a reticle conveying device, and a reticle conveying method that can achieve such a purpose.

A first aspect of the present invention is a reticle protective member that protects at least a portion of a reticle used in an exposure apparatus, wherein marks that are used to detect the position of this protective member are provided.

In this reticle protective member, since marks for detecting the position of the member are provided, the member can be used as a reticle protective member that is employed in the devices described later.

In a second aspect of the present invention, the reticle that is the object of protection is a reflective type reticle which has a pattern formed on one side, this reticle protective member has a first member that protects the surface of the reticle on which the pattern is formed and a second member that protects the opposite surface from the surface on which the pattern is formed, and the marks are respectively disposed on the first member and second member.

If this is done, the reticle can be accommodated and protected between the first member and second member. Furthermore, since marks are provided on each of the members, the positions of the respective members can be detected separately.

In a third aspect of the present invention, the reticle that is the object of protection is a reflective type reticle which has a pattern formed on one side, and this reticle protective member is a member that protects at least the region in which the pattern of the reticle is formed on the surface on which this pattern is formed.

In a reflective type reticle, it is not absolutely necessary to protect the surface on which no pattern is formed or the region in which no pattern is formed. Accordingly, in the present means, the number of parts required is reduced, and the structure is simplified. Furthermore, in cases where there are regions in which the adhesion of dirt is a problem even outside the region where the pattern is formed, such as alignment marks and ID marks, it is desirable that these regions be also protected.

A fourth aspect of the present invention is a device that conveys a reticle, wherein the device has a reticle conveying means that conveys the reticle in a state in which at least a portion of the reticle is covered by a reticle protective member used for protection, a first position measuring means which measures the position of the reticle, and a second position measuring means which measures the position of the reticle protective member.

If this is done, since the position of the reticle is measured by the first position measuring means, and the position of the reticle protective member is measured by the second position measuring means, the relative positional relationship of the reticle and the protective member can be ascertained.

In cases where the reticle is conveyed together with at least a portion of the protective member, the conveying means holds and conveys the protective member; accordingly, for example, the positioning of the reticle with respect to the conveying destination such as the reticle stage of the exposure apparatus is performed by the conveying device holding the protective member.

Since the relative positional relationship of the reticle and the protective member can be ascertained, the position to which the protective member must be conveyed in order to position the reticle accurately at the conveying destination is clear; accordingly, the reticle can be accurately positioned with respect to the conveying destination.

In a fifth aspect of the present invention, the reticle that is the object of protection is a reflective type reticle which has a pattern formed on one side, this reticle protective member has a first member that protects the surface of the reticle on which the pattern is formed and a second member that protects the opposite surface from the surface on which the pattern is formed, and the second position measuring device independently measures the positions of the first member and second member.

If this is done, not only the surface on which a pattern is formed, but also the surface on which no pattern is formed, can be protected by the protective member, so that the protection is complete.

In a sixth aspect of the present invention, the reticle that is the object of protection is a reflective type reticle which has a pattern formed on one side, and the reticle protective member is a member that protects at least the region in which the pattern of the reticle is formed on the surface on which this pattern is formed.

If this is done, then at least only the region in which the pattern is formed is protected by the protective member on the surface on which this pattern is formed; accordingly, the construction of the protective member is simplified.

In a seventh aspect of the present invention, the device has a position correcting means which corrects the positions of the reticle protective member and reticle on the basis of the position of the reticle and the position of the reticle protective member that are respectively measured by the first position measuring means and second position measuring means.

If this is done, then the device has a position correcting means that corrects the positions of the reticle protective member and reticle on the basis of the position of the reticle and the position of the reticle protective member that are respectively measured by the first position measuring means and second position measuring means; accordingly, the positions of the reticle protective member and reticle can be corrected prior to the conveying of the reticle (there may be cases in which this reticle is conveyed together with the reticle protective member) to the reticle stage, so that the reticle can be positioned in an appropriate position on the reticle stage when the conveying means conveys the reticle to the reticle stage in a predetermined sequence. Furthermore, the position correcting means in this means may be any means having the function of correcting either the position of the reticle protective member or the position of the reticle, or both.

Furthermore, in cases where the conveying means itself has a position correcting function, there is no need to provide a special position correcting means. Such cases are also included in the present means, and the conveying means also acts as a position correcting means.

In an eighth aspect of the present invention, the device has a position correcting means which corrects the positions of the first member and the reticle on the basis of the position of the reticle and the position of the reticle protective member that are respectively measured by the first position measuring means and second position measuring means.

In a ninth aspect of the present invention, the reticle conveying means conveys the reticle protected by the reticle protective member to the reticle stage, places the reticle on the reticle stage, and then conveys the reticle protective member from the reticle stage to another location, and has the function of performing the positional correction of the reticle protective member or the first member, and the reticle, by the position correcting means prior to the placement of the reticle on the reticle stage.

If this is done, then since the reticle conveying means has the function of performing the positional correction of the reticle protective member or the first member, and the reticle, by the position correcting means prior to the placement of the reticle on the reticle stage, the reticle can be positioned in an appropriate position on the reticle stage when the conveying means conveys the reticle to the reticle stage in a predetermined sequence.

Furthermore, the positional correction of the reticle is not limited to cases in which this correction is performed in an alignment stage or the like, but also includes cases in which this positional correction is accomplished by varying the conveying target position of the conveying means.

In a tenth aspect of the present invention, the reticle conveying means has the function of conveying the reticle protective member to the reticle stage and protecting the reticle by means of the reticle protective member when the reticle placed on the reticle stage is recovered from the reticle stage, and then recovering the reticle from the reticle stage by conveying the reticle protective member and reticle, and also has the function of measuring the position of the reticle protective member using the second measuring means prior to the conveying of the reticle protective member to the reticle stage.

In other words, after the position of the reticle protective member is measured beforehand, this reticle protective member is conveyed to the reticle stage, and the reticle is protected by the reticle protective member. In this case, since the position of the reticle protective member is measured beforehand, the reticle and the reticle protective member can be accurately positioned, so that damage or the generation of dirt due to abnormal contact between the two parts can be prevented.

In an eleventh aspect of the present invention, the device has the function of positioning and joining the first member and second member on the basis of the measurement results after the positions of the first member and second member are measured.

As a result of the first member and the second member being positioned and joined on the basis of the measurement results after the positions of the first member and second member are measured, damage and the generation of dirt due to abnormal contact between the two parts can be prevented. The joining of the first member and second member may be performed not only in cases where the reticle is protected, but also in cases where the reticle is not protected. For instance, this is done so that in cases where the first member and second member comprise a lower cover and an upper cover, the entry of dirt into the area between the covers is prevented as a result of the joining of these covers.

A twelfth aspect of the present invention is an exposure apparatus comprising the reticle conveying device described above.

In this exposure apparatus, the reticle can be positioned in an accurate position when conveyed to the reticle stage, and the reticle can be held on the reticle stage in this state. As a result, the mark detection range of the reticle alignment device carried on the reticle stage can be made relatively narrow; furthermore, the mark detection time can also be shortened.

A thirteenth aspect of the present invention is a reticle conveying method in which at least a portion of a reticle used in an exposure apparatus is covered by a reticle protective member used for protection, and this reticle is removed from the protective member and conveyed to the reticle stage of the exposure apparatus, wherein this method has a step in which the position of the reticle and the position of the reticle protective member are measured prior to the removal of the reticle from the protective member at an intermediate point during the conveying process.

If this is done, the reticle can be positioned in an accurate position when conveyed to the reticle stage, and the reticle can be held on the reticle stage in this state. Furthermore, the removal of the reticle can be performed either before or after the placement of the reticle on the reticle stage. Moreover, the operations described above may be performed as a modification or application, or these operations may be added.

### Brief Description of the Drawings

Figure 1 is a schematic diagram showing the relationship between a reticle, a clean filter pod (CFP) and a reticle carrier (RSP).
Figure 2 is an assembly diagram of the reticle, clean filter pod (CFP) and reticle carrier (RSP).
Figure 3 is an exploded perspective view of Figure 2.
Figure 4 is a model diagram showing an outline of an exposure apparatus and a reticle conveying device constituting one working configuration of the present invention.
Figure 5 is a diagram showing the conditions in which a reticle carrier is taken out of the in-air reticle stocker.
Figure 6 is a diagram showing the conditions in which the clean filter pod is taken out of the reticle carrier inside the reticle carrier opener.
Figure 7 is a diagram showing an outline of the load lock chamber.
Figure 8 is a diagram showing an outline of the construction of the vacuum reticle library.
Figure 9 is a schematic diagram showing the construction of the CFP opener and a state in which a clean filter pod is separated into the upper cover and lower cover, and the reticle is extracted with this reticle being carried on the lower cover.
Figure 10 is a schematic diagram showing a state in which a reticle and a lower cover are conveyed into the exposure apparatus.
Figure 11 is a diagram showing an outline of position measuring devices installed inside the CFP opener.
Figure 12 is a diagram showing an outline of the EUV exposure apparatus.

### Best Mode for Carrying Out the Invention

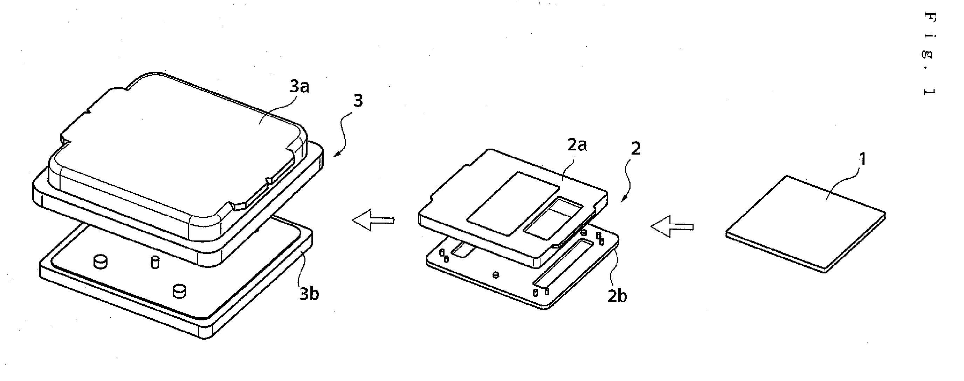

Working configurations of the present invention will be described below using the figures. However, the present invention is not limited to these working configurations. First, the relationship between a reticle and a reticle protective member on which a working configuration of the present invention is premised will be described. Figure 1 is a schematic diagram showing the relationship between a reticle, a clean filter pod (CFP) constituting the reticle protective member and a reticle carrier (also referred to as RSP: reticle SMIF pod).

The reticle 1 is protected by being accommodated inside a clean filter pod 2 having a upper cover 2a and a lower cover 2b in a configuration in which this reticle 1 is sandwiched between the upper cover 2a and lower cover 2b, and the clean filter pod 2 is further accommodated inside a reticle carrier 3 having a base stand 3a and a cover 3b. Furthermore, the reticle carrier 3 may also be referred to as "reticle SMIF pod (RSP)." Moreover, there are cases in which a plurality of clean filter pods 2 are accommodated inside a reticle carrier 3; however, in the following description of the working configurations, an example will be described in which a single clean filter pod 2 is accommodated.

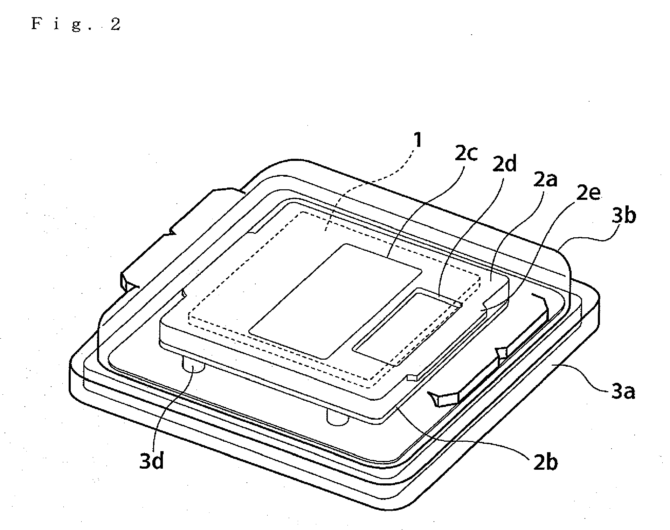

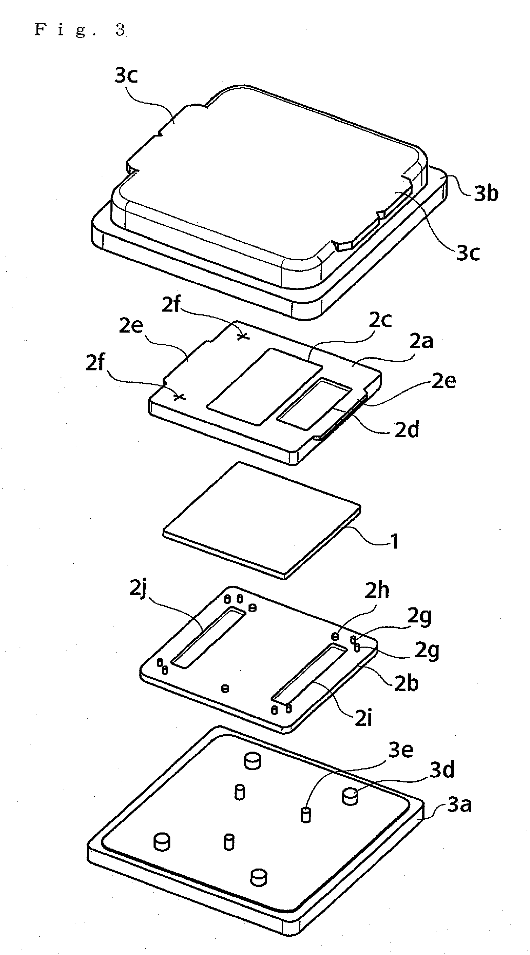

Figure 2 is an assembly diagram showing a state in which the reticle 1 is thus accommodated inside the clean filter pod 2, and the clean filter pod 2 is accommodated inside the reticle carrier 3, and Figure 3 is an exploded perspective view of this assembly. In the following figures, furthermore, constituent elements that are the same as the constituent elements in the figures described above are labeled with the same symbols, and a description of such elements may be omitted.

The cover 3b consists of a transparent resin or the like, and is provided, in two locations, with protruding parts 3c which are caught and lifted by an in-air robot 12 when the reticle carrier 3 is conveyed.

The upper cover 2a is ordinarily formed from a metal such as aluminum, and has a filter 2c and a transparent window 2d formed from glass or the like. The filter 2c is used to ensure a sufficient conductance while preventing microscopic particles such as dirt from passing through, and to reduce the difference in air pressure between the exterior and interior spaces so that the force generated by the pressure difference is not applied to the upper cover 2a and lower cover 2b even when the interior space is formed as a result of the upper cover 2a and lower cover 2b of the clean filter pod 2 being engaged. As will be described later, since the clean filter pod 2 moves back and forth between the atmosphere and a space that is in a high-vacuum state, an inner pressure adjusting mechanism via such a filter is required. The transparent window 2d is used to allow observation of the state of the reticle 1 from the outside.

Furthermore, protruding parts 2e are provided on the upper cover 2a in two locations, i.e., left and right in the figures; as will be described later, these protruding parts 2e are used to separate the upper cover 2a and lower cover 2b by catching and holding these portions on the holding member and lowering the lower cover 2b. Moreover, position detection marks 2f used to detect the position of the upper cover 2a are provided on this upper cover 2a, and as will be described later, the position of the upper cover 2a is detected by measuring the positions of these marks 2f using a position measuring device.

The lower cover 2b is ordinarily formed from a metal such as aluminum, and two positioning pins 2g forming a pair are provided at each of the four corners. When the reticle 1 is held, the positioning of the reticle 1 as seen in plan view is accomplished by these positioning pins 2g. Furthermore, reticle holding projections 2h are provided in three locations, so that the reticle 1 is supported at the three points by these reticle holding projections 2h.

Moreover, two transparent windows 2i and 2j consisting of glass or the like are formed in the lower cover 2b. These are used to allow observation of marks formed in the reticle 1 or ID marks from below the lower cover 2b in the reticle position measuring device which is the essential part of the present invention. In the figures, these windows are formed in two locations, but if the locations of the positioning marks formed in the reticle 1 are constant, such a window may be formed in only one location.

Three pins 3e that loosely mate with holes formed in the lower cover 2b (in Figure 3, since the back side of the lower cover is shown, these holes are not shown) are provided on the base stand 3a; as a result, rough positioning of the lower cover 2b and base stand 3a is accomplished. Moreover, projections 3d used to support the lower cover 2b at four points are provided on the base stand 3a.

Furthermore, marks for position measurement are also formed in the lower cover 2b as in the upper cover 2a, but these marks are not shown in Figure 3, which shows the back side of the upper cover 2a. Moreover, position measurement marks are formed in the reticle 1 as well, but these marks are similarly not shown since the back side of the reticle 1 is shown. The undersurface of the reticle 1 constitutes a pattern formation surface. The reason for this is to suppress the adhesion of dirt or the like due to gravity as much as possible on the surface on which patterns are formed.

The reticle 1 is conveyed into a reticle conveying device in a state in which this reticle 1 is doubly accommodated inside the clean filter pod 2 and reticle carrier 3 as shown in Figure 2. An outline of the reticle conveying device constituting a working configuration of the present invention will be described below.

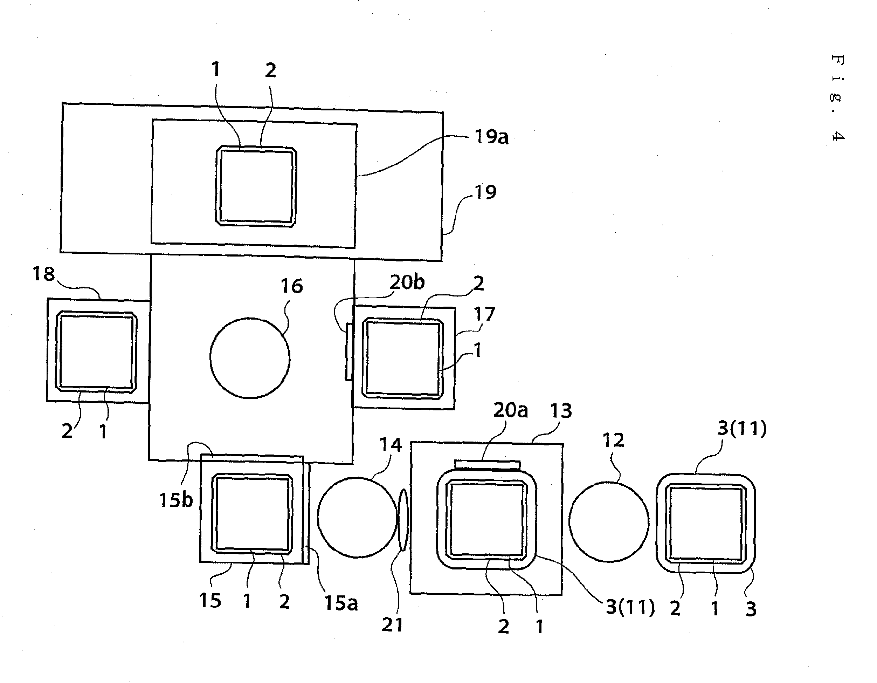

Figure 4 is a model diagram showing an outline of an exposure apparatus and a reticle conveying device constituting one working configuration of the present invention. The reticle 1 conveyed from the outside is accommodated inside an in-air reticle stocker 11. Alternatively, this reticle 1 is conveyed in a state in which this reticle 1 is accommodated inside the in-air reticle stocker 11. Then, this stocker 11 is conveyed into a reticle carrier opener 13 by an in-air robot 12, and the clean filter pod 2 is extracted from the interior of the reticle carrier 3 into clean atmosphere inside the reticle carrier opener 13. Afterward, the clean filter pod 2 is taken out and conveyed into a load lock chamber 15 by an in-air robot 14. Furthermore, the light path between the load lock chamber 15 and reticle carrier opener 13 including the in-air robot 14 is in clean atmosphere.

Then, evacuation is performed inside the load lock chamber 15, so that the interior of the load lock chamber 15 and the interior of the clean filter pod 2 are placed in a vacuum state. Following the completion of the evacuation, the clean filter pod 2 is extracted from the interior of the load lock chamber 15 by a vacuum robot 16. Specifically, two doors 15a and 15b are attached to the load lock chamber 15, and when the load lock chamber 15 is placed in a state open to the atmosphere, the door 15b is closed, while the door 15a is opened, so that the clean filter pod 2 is conveyed into this load lock chamber from the interior of the reticle carrier opener 13. Subsequently, the door 15a is closed to perform evacuation. Following the completion of the evacuation, the door 15b is opened, and the clean filter pod 2 is taken out into the vacuum region by the vacuum robot 16.

The clean filter pod 2 conveyed into the vacuum region is conveyed into a vacuum reticle library 17 and temporarily stored there. When the reticle 1 is to be actually used in an exposure apparatus 19, the clean filter pod 2 accommodating this reticle 1 is extracted from the vacuum reticle library 17 by the vacuum robot 16 and conveyed into a CFP opener 18, so that the upper cover 2a of the clean filter pod 2 is separated from the reticle 1 and lower cover 2b by the CFP opener 18. Furthermore, as will be described later, the CFP opener 18 has a prealignment mechanism for the reticle 1 and lower cover 2b.

Subsequently, the reticle 1 is conveyed to a reticle stage 19a of the exposure apparatus 19 by the vacuum robot 16 in a state in which this reticle 1 is carried on the lower cover 2b. Then, the reticle 1 is chucked by an electrostatic chuck of the reticle stage 19a, so that this reticle 1 is separated from the lower cover 2b and used for exposure. The separated lower cover 2b is returned to the interior of the CFP opener 18 by the vacuum robot 16, and waits until the use of the reticle 1 is completed in a state in which this lower cover 2b is held by the vacuum robot 16.

When the use of the reticle 1 is completed, the vacuum robot 16 conveys the lower cover 2b to the reticle stage 19a. Then, when the chucking by means of the electrostatic chuck is released in a state in which the lower cover 2b is stopped at a specified position, the reticle 1 is placed on the lower cover 2b. In this state, the vacuum robot 16 conveys the lower cover 2b into the CFP opener 18, and the upper cover 2a that has been previously separated inside the CFP opener 18 is placed over the lower cover 2b. Afterward, the vacuum robot 16 returns the clean filter pod 2 to the interior of the vacuum reticle library 17, where the clean filter pod 2 is stored.

When the clean filter pod 2 is extracted from the vacuum region, the clean filter pod 2 inside the vacuum reticle library 17 is placed inside the load lock chamber 15 by the vacuum robot 16, and the interior of the load lock chamber 15 is returned to atmospheric pressure, after which the clean filter pod 2 is returned to the interior of the reticle carrier opener 13 by the in-air robot 14, accommodated inside the reticle carrier 3, and stored inside the in-air reticle stocker 11. Then, a desired reticle carrier 3 accommodated in the in-air reticle stocker 11 is conveyed to the outside by a worker or a robot.

Furthermore, in Figure 4, 20a is a reticle carrier ID reader that reads out the identification symbol of the reticle carrier 3, and 20b is a reticle ID reader that reads out the identification symbols of the reticle 1 and clean filter pod 2. These ID readers are used to read out the information of the reticle carrier 3, reticle 1 and clean filter pod 2, so that the target reticle 1 is supplied to the exposure apparatus, or the reticle 1 that is removed from the exposure apparatus is accommodated in the specified clean filter pod 2 and reticle carrier 3. 21 is a temperature compensating lamp that adjusts the temperature of the reticle in order to compensate for the temperature drop to which the reticle 1 is subjected at the time of evacuation.

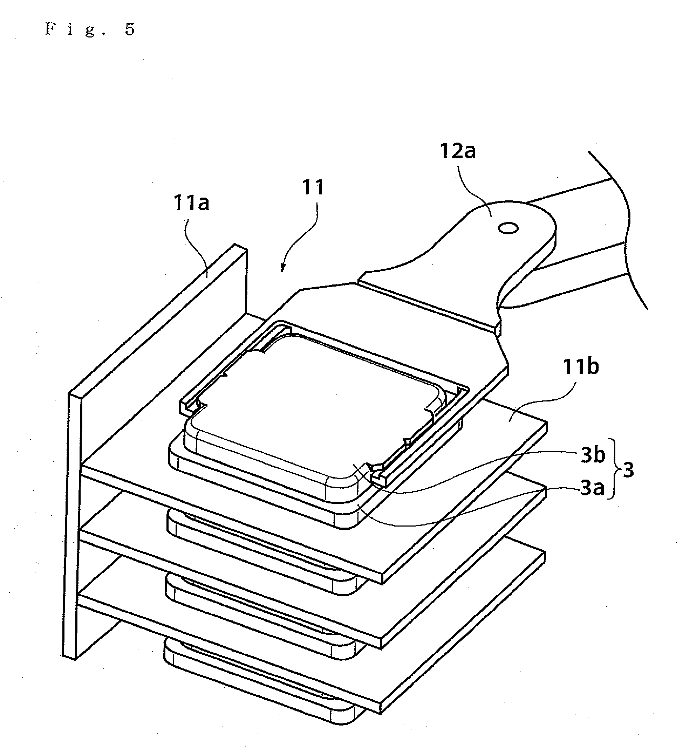

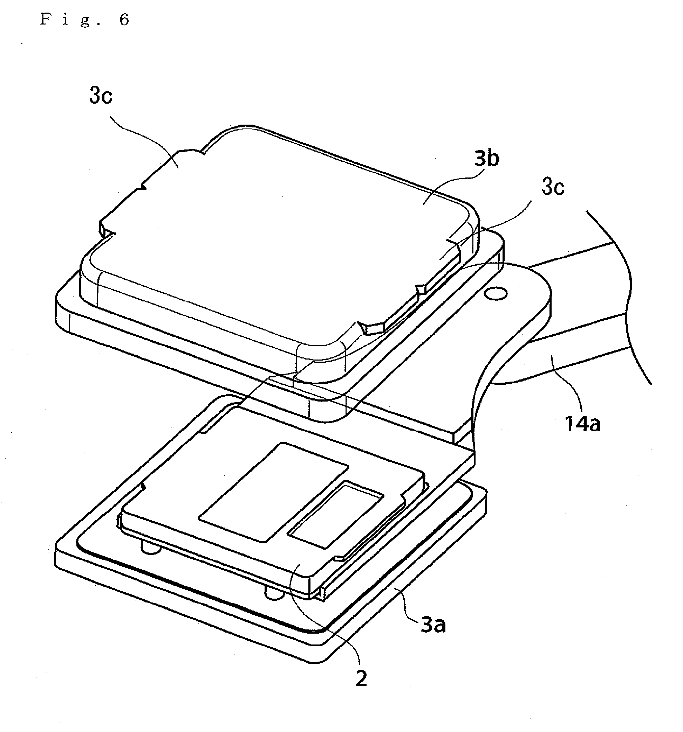

Figure 5 is a diagram showing the conditions in which a reticle carrier 3 is taken out of the in-air reticle stocker 11. The in-air reticle stocker is a rack consisting of vertical plates 11a and horizontal plates 11b (another vertical plate 11a is omitted from illustration), and a reticle carrier 3 accommodating a reticle 1 and a clean filter pod 2 is carried on each of the horizontal plates 11b. The reticle carrier 3 accommodating the selected reticle is held by the robot arm 12a of the in-air robot 12 and conveyed to the reticle carrier opener 13. The reticle carrier opener 13 has the same construction as a publicly known reticle SMIF pod (RSP), so that a detailed description of this is omitted. Figure 6 shows a state in which the cover 3b and base stand 3a of the reticle carrier 3 are separated by the reticle carrier opener 13. The housing of the reticle carrier opener 13 is not shown in the figure. However, the reticle carrier 3 disposed on the upper plate of the reticle carrier opener 13 by the robot arm 12 is fastened in place, and a clean filter pod 2 is disposed in clean atmosphere inside the reticle carrier opener by moving both the base stand 3a and a portion of the upper plate of the reticle carrier opener 13 together in the downward direction. The robot arm 14a of the in-air robot 14 enters the reticle carrier opener 13, and the clean filter pod 2 that is exposed in the clean atmosphere in a state in which this clean filter pod 2 is carried on the base stand 3a is clamped and extracted by the robot arm 14a and then accommodated inside the load lock chamber 15. Then, the cover 3b and base stand 3a are joined by raising the base stand 3a again, and the empty reticle carrier is returned to the in-air reticle stocker 11. Afterward, the reticle that is required next is selected and conveyed to the load lock chamber 15 in the same manner as described above.

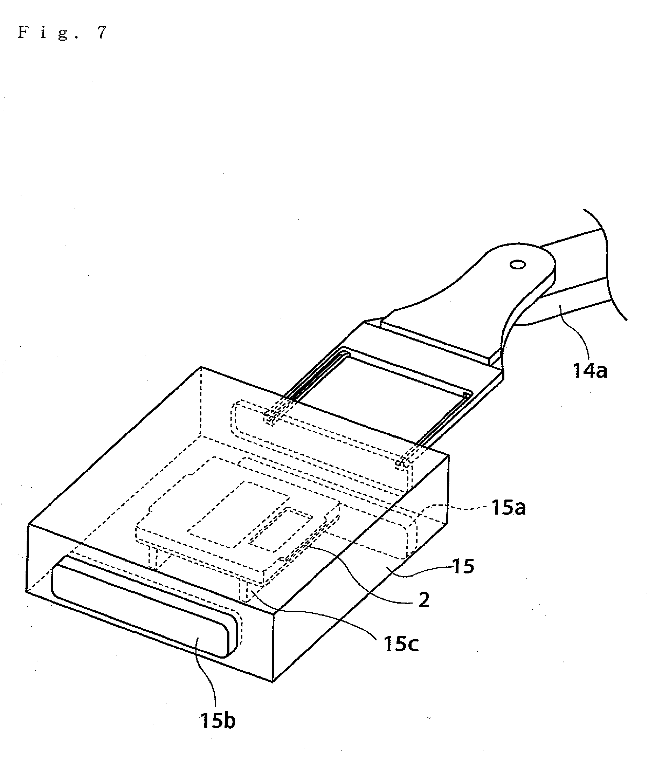

Figure 7 is a diagram showing an outline of the load lock chamber 15. This figure shows a state in which the door 15a is opened, while the door 15b is closed, and also a state in which the clean filter pod 2 conveyed by the robot arm 14a is carried on a carrying stand 15c. The door 15a is closed from this state, and evacuation is performed, after which the door 15b is opened, so that the clean filter pod 2 is taken out by the vacuum robot 16. Furthermore, the positions of the doors 15a and 15b are different between Figures 4 and 7. However, this is done this way only for the convenience of illustration, and the positional relationship of these doors can be either way. Furthermore, if the clean filter pod 2 is opened during evacuation, there is a possibility of dirt adhering to the reticle. Therefore, when the load lock chamber is evacuated or opened to atmospheric pressure, it is desirable that the pod 2 be fastened by a mechanical means or the like so that this pod 2 does not open.

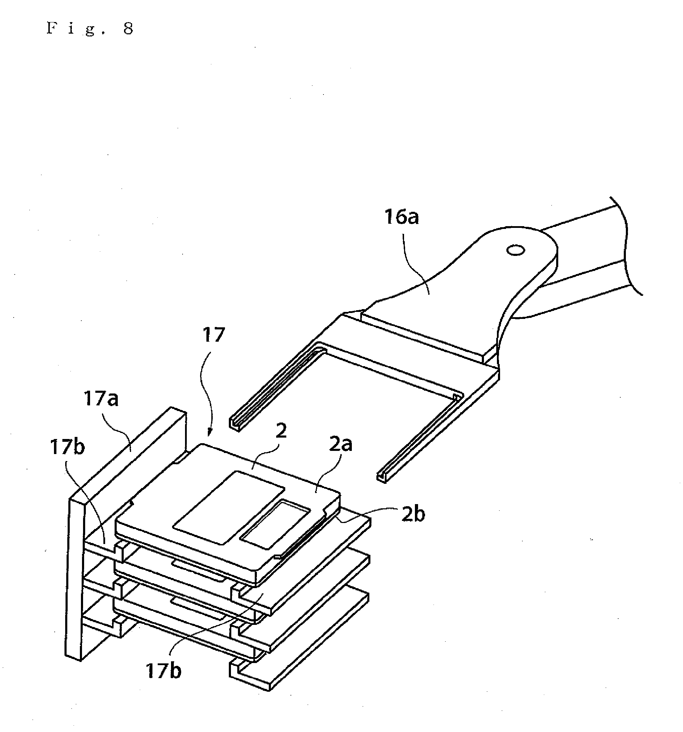

Figure 8 is a diagram showing an outline of the construction of the vacuum reticle library 17. The vacuum reticle library 17 is a rack consisting of vertical plates 17a and horizontal plates 17b (another vertical plate 17a is omitted from illustration), and the clean filter pods 2 each accommodating a reticle 1 are carried on the respective horizontal plates 17b. Furthermore, the reason that the respective horizontal plates 17b have an L shape is to create a state in which the end parts of the clean filter pods 2 float, so that the tip end parts of the vacuum robot arm 16a can be inserted underneath a lower cover 2b and scoop up this lower cover 2b.

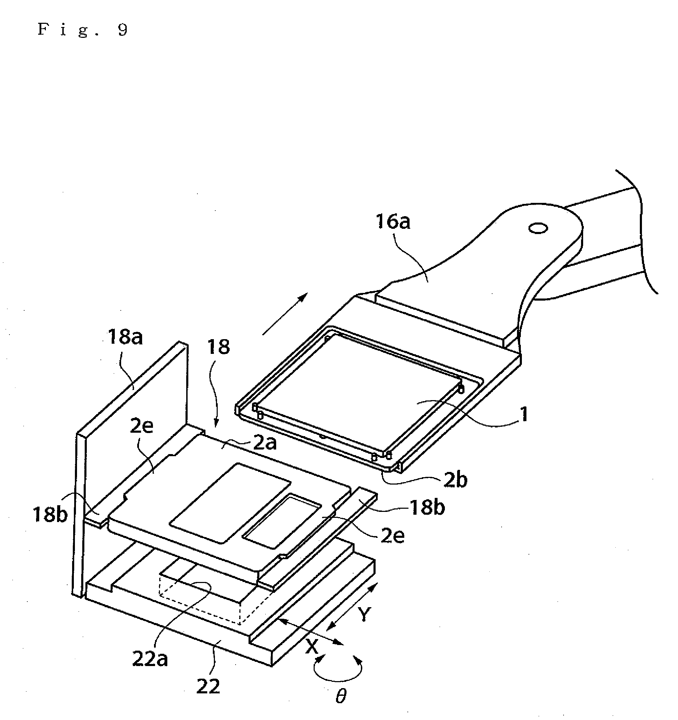

Figure 9 is a schematic diagram showing the construction of the CFP opener 18 and a state in which a clean filter pod 2 is separated into the upper cover 2a and lower cover 2b, and the reticle 1 is extracted with this reticle 1 being carried on the lower cover 2b.

The CFP opener 18 is a one-stage rack consisting of vertical plates 18a and horizontal plates 18b (another vertical plate 18a is omitted from illustration), and is devised so that the upper cover 2a is suspended as a result of the protruding parts 2e of the upper cover 2a catching the surfaces of the horizontal plates 18b.

When the clean filter pod 2 is lowered from above the horizontal plates 18b in a state in which the undersurface of the lower cover 2b is supported by the tip end parts of the vacuum robot arm 16a, the protruding parts 2e of the upper cover 2a are caught by the horizontal plates 18b. When the position of the vacuum robot arm 16a is lowered further, the lower cover 2b and the reticle 1 carried on this lower cover 2b are lowered "as is." However, the upper cover 2a is still held on the horizontal plates 18b since the protruding parts 2e are caught by the horizontal plates 18b as shown in the figure, thus accomplishing the separation of the upper cover 2a from the lower cover 2b and reticle 1. The reticle 1 carried on the lower cover 2b can be taken out by pulling the vacuum robot arm 16a in the arrow direction in this state.

Moreover, an alignment stage 22 is installed in the CFP opener 18. This alignment stage 22 is devised so that this stage can move in the X direction and the Y direction perpendicular to this X direction, and can rotate (θ) using the Z direction perpendicular to these directions as an axis as shown in the figure. Furthermore, the horizontal plates 18b on which the upper cover 2a is placed are fixed in this example; however, in cases where it is desired to adjust the position of the upper cover, it would also be possible to cause these plates to move by providing a driving means.

When it is desired to perform alignment (positional adjustment) of the reticle 1, the lower cover 2b can be placed on the alignment stage 22 by lowering the vacuum robot arm 16a in a state in which the lower cover 2b on which the reticle 1 is carried is clamped between the tip end parts of the vacuum robot arm 16a. The central portion of the alignment stage 22 is formed in a convex shape so that the vacuum robot arm 16a can be lowered to a position which is such that the tip end parts of the vacuum robot arm 16a do not touch the lower cover 2b in a state in which the lower cover 2b is carried on the alignment stage 22. Furthermore, a through-hole 22a is formed in the central portion of the alignment stage 22, and as will be described later, this is used to allow the detection of the position of the lower cover 2b and the position of the reticle 1 using position detection devices.

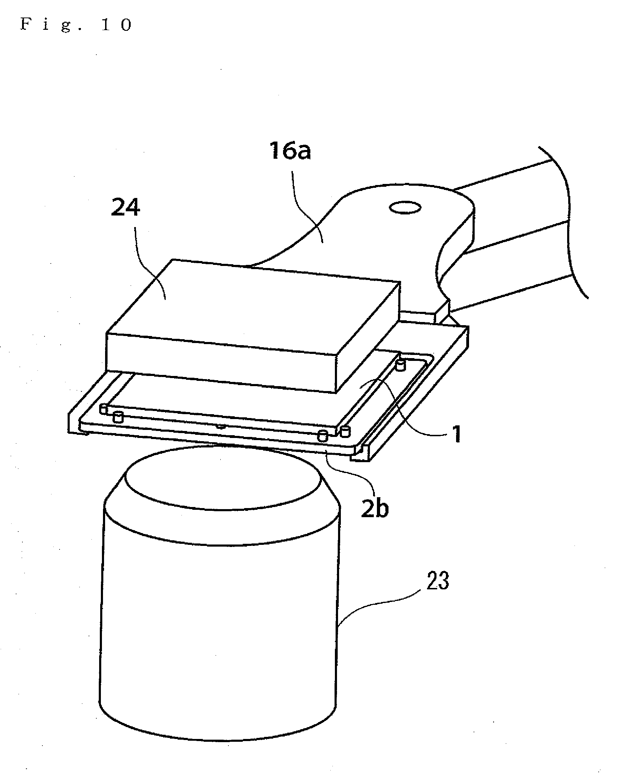

Figure 10 is a schematic diagram showing a state in which the reticle 1 and lower cover 2b are conveyed into the exposure apparatus. 23 is the lens barrel of the exposure apparatus, and 24 is the electrostatic chuck provided on the reticle stage 19a (not shown in Figure 10) of the exposure apparatus. When the reticle 1 carried on the lower cover 2b is conveyed to a specified position by the vacuum robot arm 16a and chucked by the electrostatic chuck 24, only the reticle 1 is fastened to the reticle stage 19a, while the lower cover 2b is still held by the vacuum robot arm 16a. In this state, the lower cover 2b is returned to the interior of the CFP opener 18 by the vacuum robot arm 16a. Furthermore, it is desirable that the reticle be pressed against the electrostatic chuck 24 by the vacuum robot 16 or another means prior to the chucking by the electrostatic chuck 24.

The lower cover 2b may be caused to wait inside the CFP opener 18 in this manner until the use of the reticle 1 is completed. However, in order to prevent dirt or the like from entering the lower cover 2b, the clean filter pod 2 may be returned to a state in which the upper cover 2a and lower cover 2b are joined, so that the empty clean filter pod 2 may be returned inside the vacuum reticle library 17 using the vacuum robot 16 and stored there.

In this case, the system may be devised in the following manner: namely, at the completion of the use of a reticle 1, the corresponding clean filter pod 2 is identified by the reticle ID reader 20b and extracted to be conveyed to the CFP opener 18, and after the upper cover 2a and lower cover 2b are separated in the method described above, the lower cover 2b is moved to the position of the reticle stage 19a by the vacuum robot 16, so that the reticle 1 is received.

If such a construction is used, the vacuum robot 16 becomes free. Therefore, while the reticle is used for exposure, another reticle can be conveyed to the vacuum reticle library 17, and the reticle to be used next can be aligned.

Moreover, the clean filter pod 2 may also be held by the vacuum robot arm 16a and caused to wait inside the CFP opener 18 in a state in which the upper cover 2a and lower cover 2b are joined. If this is done, the conveying time can be shortened compared to a case in which an empty clean filter pod 2 is returned to the vacuum reticle library 17, while also preventing dirt or the like from entering the interior of the lower cover 2b.

Thus, a method has been described in which the reticle 1 is recovered to the clean filter pod 2 from the reticle stage 19. With regard to a method in which the clean filter pod 2 is conveyed out by being accommodated inside the reticle carrier 3, it would be sufficient to reverse the step in which the clean filter pod 2 is taken out of the reticle carrier 3 and conveyed into the CFP opener 18 as described above, so that no further description is necessary for a person skilled in the art.

In the description above, the clean filter pod 2 that protects the reticle 1 by accommodating this reticle 1 inside was constructed from an upper cover 2a and a lower cover 2b. However, there are cases in which the protection of the reticle 1 may be performed only for the undersurface on which the pattern is formed or only for a region of the undersurface where protection is desired such as the pattern formation region. In such cases, the upper cover 2a is unnecessary, and the shape of the lower cover is also different. In cases where such a reticle protective member is handled, a mechanism for separating the upper cover 2a in the CFP opener 18 is unnecessary; it is sufficient if there are simply an alignment stage 22 for performing the alignment of the reticle 1 and position measuring devices (described later). Therefore, the construction of the apparatus is correspondingly simplified. Furthermore, in either case, when the alignment is performed using a vacuum robot; the alignment stage 22 also becomes unnecessary in some cases.

In addition, the vacuum reticle library 17 and CFP opener 18 are separate devices in the above description, but these devices may also be integrated into a single device. Specifically, this can be accomplished by making one of the racks of the vacuum reticle library 17 to have a construction similar to that of the rack of the CFP opener 18, and installing an alignment stage 22 inside the vacuum reticle library 17.

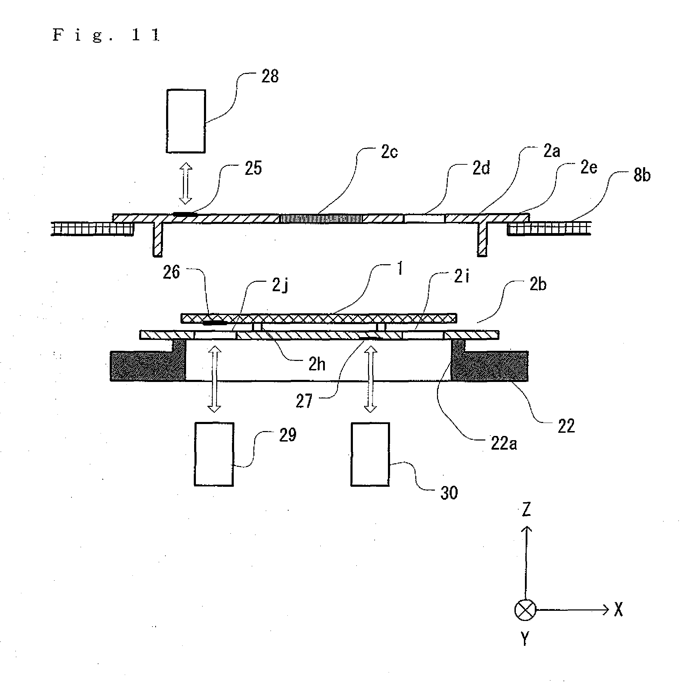

Figure 11 shows an outline of position measuring devices installed inside the CFP opener 18. In the present working configuration, position measuring devices for the reticle 1, upper cover 2a and lower cover 2b are provided, and marks for position measurement are respectively formed on the reticle 1, upper cover 2a and lower cover 2b corresponding to these position measuring devices. Position measurement marks 25 (indicated as 2f in Figure 3) are formed on the upper cover 2a, position measurement marks 26 are formed on the reticle 1, and position measurement marks 27 are formed on the lower cover 2b.

Furthermore, a position measuring device 28 is provided in order to detect the positions of the position measurement marks 25, a position measuring device 29 is provided in order to detect the positions of the position measurement marks 26, and a position measuring device 30 is provided in order to detect the positions of the position measurement marks 27. As examples of the shapes of the respective position measurement marks 25, 26 and 27, cruciform marks in which lines parallel to the X direction and lines parallel to the Y direction in Figure 11 are crossed, and a two-dimensional line-and-space pattern in which line-and-space patterns are disposed both in the X direction and Y direction, are common. In the present working configuration, two such marks are formed on each of the upper cover 2a, reticle 1 and lower cover 2b in the Y direction in Figure 11 (for example, see 2f in Figure 3). Accordingly, each of the position measuring devices 28 through 30 also has two detectors.

The position measuring device 28 measures the position of the upper cover 2a by measuring the positions of the position measurement marks 25 when the upper cover 2a is placed in a state in which this upper cover 2a is suspended from the horizontal plates 18b. The position measuring device 29 measures the positions of the position measurement marks 26 formed on the undersurface of the reticle 1 through the through-hole 22a and transparent window 2j when the lower cover 2b is placed in a state in which this lower cover 2b is carried on the alignment stage 22, thus measuring the position of the reticle 1. The position measuring device 30 measures the positions of the position measurement marks 27 formed on the undersurface of the lower cover 2b through the through-hole 22a and transparent window 2jwhen the lower cover 2b is placed in a state in which this lower cover 2b is carried on the alignment stage 22, thus measuring the position of the lower cover 2b.

The constructions of the position measuring devices 28, 29 and 30 are such that the images of the position measurement marks 25, 26 and 27 which are cruciform lines are picked up by a two-dimensional imaging device through an optical microscope, so that the positions in the X direction and Y direction of the position measurement marks 25, 26 and 27 are detected. Since a universally known microscope used in a conventional exposure apparatus or the like can be used, a description of this microscope is omitted. Furthermore, since two each of the position measurement marks 25, 26 and 27 are formed, the rotation of the upper cover 2a, reticle 1 and lower cover 2b about the Z axis can be detected.

The alignment procedure up to the placement of the reticle on the reticle stage following the separation of the upper cover 2a and lower cover 2b by means of the CFP opener 18 will be described. The position measurement marks 27 of the lower cover 2b separated by the opener 18 are measured by the position measuring device 30. With regard to this position measuring device 30, a relatively low-magnification microscope may be used, and a microscope having a relatively wide mark detection region is desirable. The alignment stage 22 is moved in the X and Y directions and in the rotational direction about the Z axis so that the marks 27 measured by the position measuring device 30 are disposed in specified positions. Afterward, the position measurement marks 26 formed on the reticle 1 are measured by the position measuring device 29. A relatively high-magnification microscope is desirable for this position measuring device. Although a high-magnification microscope tends to have a relatively narrow mark detection region, the alignment of the marks 27 can be performed so that the marks 26 are located within this relatively narrow detection region. Based on the measurement results of the marks 26, the alignment stage is moved in the X and Y directions and in the rotational direction about the Z axis so that the marks 26 are disposed in specified positions. The reticle 1 and lower cover 2b that are thus positioned are again held by the vacuum robot arm, and then conveyed to the reticle stage, so that the reticle 1 is fastened to the reticle stage. The reticle 1 is positioned on the reticle stage using another alignment system; here, since the reticle is aligned prior to the placement on the reticle stage as described above, the alignment system placed on the reticle stage can make the mark detection region relatively narrow, so that measurement precision can be easily increased. Furthermore, the positioning can also be performed using the vacuum robot arm without moving the alignment stage 26. In this case, this can be accomplished by measuring the positions of the position measurement marks 27, then adjusting the position of the vacuum robot arm, subsequently measuring the positions of the position measurement marks 26, and conveying the reticle to the reticle stage taking into account these position measurement results. Moreover, there are also cases in which the alignment stage 22 and vacuum robot arm are used in combination. For example, it is possible to perform the positioning in the X and Y directions using the vacuum robot arm 16 and to perform the adjustment of the rotation about the Z axis using the alignment stage 22. In such cases, the positioning of the lower cover 2b is performed by performing position measurements on the alignment stage 22, then lifting the lower cover 2b using the vacuum robot arm to adjust the position of the lower cover in the X and Y directions, and then placing the lower cover 2b on the alignment stage 22. The adjustment of the rotation about the Z axis is performed by the alignment stage 22 before or after the adjustment by means of the vacuum robot arm. Subsequently, the position measurement marks 26 are measured, and the adjustment of the rotation about the Z axis is performed by the alignment stage 22, after which the positions in the X and Y directions are adjusted using the vacuum robot arm at the time of the conveying of the reticle to the reticle stage, and the reticle is placed on the reticle stage.

The position of the reticle 1 and the position of the lower cover 2b are measured for such a purpose. Furthermore, if the detection region of the position measuring device 29 that measures the position measurement marks 26 provided on the reticle 1 is sufficiently wide, so that measurements are always possible, then it is not necessary to measure the marks 27 for positioning that are provided on the lower cover 2b.

Moreover, it is desirable to measure the position of the lower cover 2b before the lower cover 2b is conveyed to the reticle stage 19a in order to recover the reticle 1 from the reticle stage 19a following the completion of the use of the reticle 1. If the positional relationship between the reticle 1 and lower cover 2b is not in the stipulated position in cases where the chucking by means of the electrostatic chuck 24 of the reticle stage 19a is released so that the reticle 1 is placed on the lower cover 2b, then the reticle 1 and lower cover 2b make abnormal contact (for example, the reticle 1 is not well fitted between the positioning pins 2g shown in Figure 3, so that this reticle 1 assumes a floating state or rubs against the pins), which causes damage to the reticle 1, the generation of dirt, or the like.

In order to prevent this, the position of the lower cover 2b is ascertained by measuring the positions of the position measurement marks 27, thus ascertaining the relative positional relationship between the reticle 1 and lower cover 2b in cases where the lower cover 2b is conveyed to the reticle stage 19a by the vacuum robot arm 16a, and the vacuum robot arm 16a is stopped at a specified position, so that the position at which the vacuum robot arm 16a is stopped is corrected by the amount of positional deviation. Alternatively, after ascertaining the relative positional relationship between the reticle 1 and lower cover 2b in cases where the vacuum robot arm 16a is stopped at a specified position, and correcting the position of the lower cover 2b by the alignment stage 22 by the amount of positional deviation, then the reticle is conveyed to a specified position on the reticle stage 19a by the vacuum robot 16.

The position measurement of the upper cover 2a by measuring the positions of the position measurement marks 25 is performed in order to join the upper cover 2a and lower cover 2b accurately when the use of the reticle 1 is completed so that the reticle 1 is recovered by being carried on the lower cover 2b, or in cases where the upper cover and lower cover are closed and caused to wait in order to prevent dirt from entering the interior of the pod as described above. Specifically, the lower cover 2b is lifted by the vacuum robot arm 16a inside the CFP opener 18 and fitted in the upper cover 2a that is suspended from the horizontal plates 18b; however, if there is a positional deviation between the upper cover 2a and lower cover 2b in this case, the lower cover 2b cannot be joined well with the upper cover 2a, so that there is a danger that these parts will damage each other, or that dirt will be generated by abnormal contact.

Therefore, before the lower cover 2b is fitted in the upper cover 2a, the relative positions of the upper cover 2a and lower cover 2b are measured, and the lower cover 2b is raised after adjusting the position of the vacuum robot arm 16a so that these parts fit well, or the lower cover 2b is lifted by the vacuum robot arm 16a after adjusting the position of the lower cover 2b by the alignment stage 22 in cases where there is an alignment stage 22.

In this case, furthermore, in cases where the reticle is accommodated in the lower cover 2b in a position where the position of the reticle 1 is inappropriate with respect to the lower cover 2b, if the upper cover and lower cover are closed in this state, the reticle may be damaged in some instances. Accordingly, it is desirable to measure not only the positions of the upper cover 2a and lower cover 2b but also the position of the reticle 1, and to measure whether or not the reticle 1 is disposed in a normal position with respect to the lower cover 2b. If the position of the reticle is inappropriate, then one of the following methods can be performed: namely, a method in which the reticle is returned to the reticle stage again to cause this reticle to be chucked, and the position of the lower cover is adjusted, after which the reticle is again placed on the lower cover, a method in which another mechanism for correcting only the position of the reticle is provided, and a method in which the reticle is conveyed to the outside of the device "as is" via the load lock chamber without placing the upper cover. Furthermore, in cases where the reticle is conveyed to the outside of the device without placing the upper cover, the upper cover is also conveyed separately to the outside of the device.

Moreover, it goes without saying that in the case of a system in which no upper cover 2a is present as a protective member, with only a lower cover 2b being present, so that only the pattern surface of the reticle 1 is protected, the positioning of the upper cover 2a and lower cover 2b is unnecessary.

Furthermore, in the above description, positioning is performed only with respect to the X and Y directions and rotation about the Z axis. However, it would also be possible to perform positioning with respect to the direction of the Z axis, rotation about each of the X and Y axes, and the like.

In addition, in the above description, an EUV exposure apparatus was described as an example. However, the present invention can be applied as needed to exposure apparatuses other than EUV exposure apparatuses, inspection devices, and conveying devices for mask cleaning devices or the like.

## Claims

1. A reticle protective member that protects at least a portion of a reticle used in an exposure apparatus, wherein alignment marks that are used to detect the position of this protective member are provided.

2. The reticle protective member according to Claim 1, wherein the reticle that is the object of protection is a reflective type reticle which has a pattern formed on one side, this reticle protective member has a first member that protects the surface of the reticle on which the pattern is formed and a second member that protects the opposite surface from the surface on which the pattern is formed, and the alignment marks are respectively disposed on the first member and second member.

3. The reticle protective member according to Claim 1, wherein the reticle that is the object of protection is a reflective type reticle which has a pattern formed on one side, and this reticle protective member is a member that protects at least the region in which the pattern of the reticle is formed on the surface on which this pattern is formed.

4. A reticle conveying device that conveys a reticle, wherein the device has a reticle conveying means that conveys the reticle in a state in which at least a portion of the reticle is covered by a reticle protective member used for protection, a first position measuring means which measures the position of the reticle, and a second position measuring means which measures the position of the reticle protective member.

5. The reticle conveying device according to Claim 4, wherein the reticle that is the object of protection is a reflective type reticle which has a pattern formed on one side, this reticle protective member has a first member that protects the surface of the reticle on which the pattern is formed and a second member that protects the opposite surface from the surface on which the pattern is formed, and the second position measuring device independently measures the positions of the first member and second member.

6. The reticle conveying device according to Claim 4, wherein the reticle that is the object of protection is a reflective type reticle which has a pattern formed on one side, and the reticle protective member is a member that protects at least the region in which the pattern of the reticle is formed on the surface on which this pattern is formed.

7. The reticle conveying device according to Claim 4, wherein the device has a position correcting means which corrects the positions of the reticle protective member and reticle on the basis of the position of the reticle and the position of the reticle protective member that are respectively measured by the first position measuring means and second position measuring means.

8. The reticle conveying device according to Claim 5, wherein the device has a position correcting means which corrects the positions of the first member and the reticle on the basis of the position of the reticle and the position of the reticle protective member that are respectively measured by the first position measuring means and second position measuring means.

9. The reticle conveying device according to Claim 7, wherein the reticle conveying means conveys the reticle protected by the reticle protective member to the reticle stage, places the reticle on the reticle stage, and then conveys the reticle protective member from the reticle stage to another location, and has the function of performing the positional correction of the reticle protective member or the first member, and the reticle, by the position correcting means prior to the placement of the reticle on the reticle stage.

10. The reticle conveying device according to Claim 8, wherein the reticle conveying means conveys the reticle protected by the reticle protective member to the reticle stage, places the reticle on the reticle stage, and then conveys the reticle protective member from the reticle stage to another location, and has the function of performing the positional correction of the reticle protective member or the first member, and the reticle, by the position correcting means prior to the placement of the reticle on the reticle stage.

11. The reticle conveying device according to Claim 4, wherein the reticle conveying means has the function of conveying the reticle protective member to the reticle stage and protecting the reticle by means of the reticle protective member when the reticle placed on the reticle stage is recovered from the reticle stage, and then recovering the reticle from the reticle stage by conveying the reticle protective member and reticle, and also has the function of measuring the position of the reticle protective member using the second measuring means prior to the conveying of the reticle protective member to the reticle stage.

12. The reticle conveying device according to Claim 5, wherein the device has the function of positioning and joining the first member and second member on the basis of the measurement results after the positions of the first member and second member are measured.

13. The reticle conveying device according to Claim 5, wherein the device has the function of positioning and joining the first member and second member on the basis of the measurement results after the positions of the first member and second member are measured.

14. An exposure apparatus comprising the reticle conveying device according to Claim 4.

15. A reticle conveying method in which at least a portion of a reticle used in an exposure apparatus is covered by a reticle protective member used for protection, and this reticle is removed from the protective member and conveyed to the reticle stage of the exposure apparatus, wherein this method has a step in which the position of the reticle and the position of the reticle protective member are measured prior to the removal of the reticle from the protective member at an intermediate point during the conveying process.
